# FASCICULE DE BREVET EUROPEEN

(11) **EP 3 847 075 B1**
(45) Date de publication et mention de la délivrance du brevet: **04.05.2022**
(21) Numéro de dépôt: 19762933.0
(22) Date de dépôt: 30.08.2019
(51) Int. Cl.: G01K 1/024, G01K 1/08, G01K 7/00, H01L 35/28, B61K 9/04

(54) **DISPOSITIF EMBARQUE DE MESURE DE TEMPERATURE AUTONOME ET PROCEDE MIS EN OEUVRE PAR UN TEL DISPOSITIF**
AUTONOME BORDEIGENE TEMPERATURMESSVORRICHTUNG UND VON DIESER VORRICHTUNG IMPLEMENTIERTES VERFAHREN
AUTONOMOUS ON-BOARD TEMPERATURE MEASUREMENT DEVICE AND METHOD IMPLEMENTED BY THIS DEVICE

(30) Priorité: 03.09.2018 FR 1857905
(43) Date de publication de la demande: 14.07.2021
(73) Titulaire: Centre national de la recherche scientifique, 75016 Paris (FR); Université Grenoble Alpes, 38400 Saint-Martin-d'Hères (FR)
(72) Inventeur: TAINOFF, Dimitri, 38000 Grenoble (FR); BOURGEOIS, Olivier, 38380 Saint Laurent Du Pont (FR); PROUDHOM, Anaïs, 38000 Grenoble (FR)
(74) Mandataire: IPAZ
(86) Numéro de dépôt international: PCT/EP2019/073274
(87) Numéro de publication internationale: WO 2020/048894

(56) Documents cités:
- WO-A1-2015/100425
- RS-A1- 20 140 604
- Dejan Milic ET AL: "Characterization of commercial thermoelectric modules for application in energy harvesting wireless sensor nodes", Applied Thermal Engineering 121 (2017) 74-82, 13 avril 2017 (2017-04-13), pages 74-82, XP055596764, The Netherlands Extrait de l'Internet: URL:https://doi.org/10.1016/j.applthermale ng.2017.04.037 [extrait le 2019-06-14]
- Hervé Lenon: "Kit de surveillance autonome et communicant pour ferroviaire et engins roulants (NTN-SNR)", European Mechatronics Meeeting (EMM), 2-3 June 2015, Senlis (France), 4 June 2015 (2015-06-04), XP055596697,

## Description

L'invention concerne un dispositif de mesure de température autonome et un procédé mis en œuvre par un tel dispositif.

Le domaine de l'invention est le domaine des dispositifs de mesure de température, et plus particulièrement, le domaine des dispositifs embarqués de mesure de température autonomes.

### ETAT DE LA TECHNIQUE

On connait les dispositifs embarqués de mesure de température comprenant une batterie pour alimenter un capteur de température. L'autonomie de ces dispositifs est limitée à l'autonomie de la batterie. D'autre dispositifs embarqués comprennent un capteur de température relié à une source d'énergie distante des dispositifs. Ces dispositifs permettent un fonctionnement continu du capteur de température mais nécessitent une mise en œuvre complexe.

On connait aussi les dispositifs embarqués de mesure de température comprenant un thermo-générateur configuré pour convertir une énergie thermique en énergie électrique, et relié à des composants électroniques pour alimenter un capteur de température. Ces dispositifs manquent donc de robustesse et restent coûteux à entretenir.

Un exemple d'un tel dispositif de mesure de température est décrit dans l'article Dejan Milic et al.: "Characterization of commercial thermoelectric modules for application in energy harvesting wireless sensor nodes", Applied Thermal Engineering 121 (2017) 74-82, 13 avril 2017 (2017-04-13), pages 74-82, Pays-Bas, et dans la demande de brevet.

La demande de brevet WO2015/100425A1 et l'article Hervé Lenon: "Kit de surveillance autonome et communicant pour ferroviaire et engins roulants (NTN-SNR)", European Mechatronics Meeeting (EMM), 2-3 Juin 2015, Senlis (France), illustrent des applications ferroviaires mettant en œuvre des dispositifs de mesure de température embarqués.

Un but de la présente invention est de proposer un dispositif de mesure de température plus robuste et/ou moins coûteux et/ou plus simple à réaliser et à installer.

### EXPOSE DE L'INVENTION

Au moins un des objectifs précités est atteint par un dispositif de mesure de température tel que défini dans la revendication 1.

Avec le dispositif selon l'invention, la carte électronique est agencée à distance de la surface de mesure. La carte électronique est ainsi protégée des températures extrêmes que présentent la surface de mesure. Le dispositif selon l'invention est donc plus robuste. De plus, le dispositif selon l'invention ne nécessite pas de branchements à une source d'alimentation. Le dispositif selon l'invention est moins coûteux et moins complexe à mettre en œuvre.

La surface de mesure peut être à une température comprise entre -100°C et 500°C, en particulier comprise entre -50°C et 250°C.

La carte électronique peut fonctionner à des températures maximales comprises entre 85°C et 125°C. Avec l'agencement à distance de la carte électronique, le dispositif selon l'invention fonctionne pour une surface de mesure ayant des températures supérieures à celles supportées par la carte électronique.

Avantageusement, le dispositif selon l'invention peut comprendre une ouverture du côté de la surface de mesure pour permettre un contact entre la surface de mesure et l'échantillon.

L'ouverture peut avoir les dimensions de la surface de mesure.

Dans une version de réalisation du dispositif selon l'invention, le capteur de température et/ou le thermo-générateur peuvent être situés entre la surface de mesure et la carte électronique.

Dans un mode de réalisation avantageux du dispositif selon l'invention, la carte électronique peut comprendre au moins un convertisseur de tension reliant le thermo-générateur au capteur de température.

En particulier, le convertisseur de tension peut être configuré pour élever la tension produite par le thermo-générateur.

Préférentiellement, la carte électronique peut comprendre un microcontrôleur agencé pour contrôler :
- au moins un moyen de stockage de l'énergie électrique convertie par le thermo-générateur et agencé pour alimenter le capteur de température avec au moins une partie de cette énergie électrique stockée, et/ou
- un moyen de communication d'une mesure de température dudit capteur de température avec un serveur distant.

Le serveur distant peut être agencé à une distance comprise entre 1 m et 25 km du dispositif selon l'invention.

En particulier, le microcontrôleur peut être agencé pour contrôler le convertisseur de tension.

Avantageusement, le capteur de température peut être un thermocouple.

La carte électronique peut comprendre un convertisseur analogique/numérique pour convertir la mesure du capteur de température en une donnée numérique de mesure de température.

Alternativement, ou en plus, Le capteur de température peut être tout capteur de température numérique.

Préférentiellement, le thermo-générateur peut être un module Peltier.

En particulier, le thermo-générateur peut être un module Peltier du type massif tridimensionnel ou du type microsystème électromécanique (« MEMS » en anglais).

L'énergie électrique produite peut être proportionnelle à la différence de température entre la surface de mesure et la surface de dissipation.

Le dissipateur peut être agencé pour refroidir la surface de dissipation de sorte à diminuer la température de la surface de dissipation.

Avantageusement, le dissipateur peut être fixé à la surface de dissipation pour assurer un contact thermique par une colle thermique, une pâte thermique, ou tout matériau adhérant, souple ou rigide, permettant un échange thermique.

Alternativement, ou en plus, le dissipateur peut être fixé à la surface de dissipation par brasage.

Cet agencement permet une meilleure dispersion thermique entre la surface de dissipation du thermo-générateur et le dissipateur. La différence de température entre la surface de mesure et la surface de dissipation est plus élevée. L'énergie électrique produite par le thermo-générateur est ainsi augmentée.

Le boitier peut comprendre au moins une ouverture de passage d'air débouchant au niveau du dissipateur thermique.

En particulier, le boitier peut comprendre une pluralité d'ouvertures situées sur au moins deux faces du boitier en regard l'une de l'autre.

Lesdites ouvertures permettent de produire un flux d'air, par convection naturelle ou forcée, traversant le dissipateur. Cet agencement permet de dissiper la chaleur et/ou le froid dans le boitier et donc simultanément de protéger la carte électronique et d'augmenter l'énergie électrique produite.

En particulier, la distance entre la carte électronique et la surface de mesure peut être supérieure ou égale à une distance minimale fonction de la résistance thermique du boitier afin de ne pas dépasser une température maximale d'utilisation de la carte électronique.

À titre d'exemple, par exemple pour un boitier en aluminium, la distance entre la surface de mesure et la carte électronique peut être supérieure ou égale à 1 cm, de préférence supérieure ou égale à 1,5 cm, en particulier égale à 2,5 cm.

Le boitier du dispositif selon l'invention peut avoir une hauteur, une largeur et/ou une hauteur comprises entre 2,5 cm et 5 cm. Ainsi, le dispositif selon l'invention est compact et peu encombrant.

Dans un mode de réalisation du dispositif selon l'invention, la carte électronique peut être disposée dans un logement l'isolant thermiquement de la surface de mesure.

Le logement peut comprendre un matériau isolant thermiquement, telle que de la mousse polyuréthane.

Le logement peut être situé dans le boitier et peut comprendre au moins une ouverture permettant le passage d'un câble reliant la carte électronique au thermo-générateur.

Selon un mode de réalisation, le dispositif selon l'invention peut comprendre au moins un moyen de mesure d'une donnée relative à l'environnement dudit dispositif et la carte électronique peut être agencée pour alimenter ledit moyen de mesure avec au moins une partie de l'énergie électrique convertie par le thermo-générateur.

Le moyen de mesure peut être un capteur tel qu'un capteur d'effort, un capteur de pression, un capteur d'humidité, etc.

En particulier, le moyen de mesure peut être disposé au niveau de la surface de mesure.

Avantageusement, le thermo-générateur peut comprendre le capteur de température et/ou au moins un moyen de mesure.

Dans un mode de réalisation avantageux, le dispositif selon l'invention peut comprendre des moyens de fixation de la surface de mesure sur l'échantillon.

Les moyens de fixation peuvent être tout type de fixation amovible ou non, tels que des moyens de fixation par clips, par vissage, par collage, par emboitement, etc.

Suivant un aspect de l'invention, il est proposé un système de mesure de température comprenant un dispositif selon l'invention assemblé à un échantillon caractérisé en ce que la surface de mesure formée par le thermo-générateur et le capteur de température est en contact thermique avec l'échantillon de sorte à en mesurer une température.

En particulier, l'échantillon peut être une pièce d'un véhicule ou un élément de tuyauterie. De préférence, dans le cas d'un élément de tuyauterie, le dispositif selon l'invention n'est pas à l'intérieur de cet élément de tuyauterie mais seule la surface de mesure du thermo-générateur est en contact d'une seule face extérieure de cet élément de tuyauterie.

Suivant un aspect de l'invention, il est proposé un véhicule, en particulier ferroviaire, comprenant au moins un dispositif selon l'invention dont la surface de mesure est située au niveau d'au moins une boite d'essieu dudit véhicule et prévu pour mesurer une température de ladite au moins une boite d'essieu.

Suivant un aspect de l'invention, il est proposé un procédé de mesure de température d'un échantillon tel que défini dans la revendication 11.

En particulier, le capteur de température et/ou le thermo-générateur peuvent être situés entre la surface de mesure et la carte électronique.

Avantageusement, le procédé selon l'invention peut comprendre une étape d'élévation d'une tension de l'énergie électrique convertie par au moins un convertisseur de tension reliant le thermo-générateur au capteur de température.

Dans une version de réalisation, le procédé selon l'invention peut comprendre :
- au moins une étape de stockage de l'énergie électrique convertie par le thermo-générateur par au moins un moyen de stockage agencé pour alimenter le capteur de température avec au moins une partie de cette énergie électrique stockée, et/ou
- au moins une étape de communication d'une mesure de température dudit capteur avec un serveur distant.

Préférentiellement, le procédé selon l'invention peut comprendre une étape de dissipation thermique d'une surface, dite de dissipation, du thermo-générateur opposée à la surface de mesure de sorte que la température de la surface de dissipation est différente de la température de la surface de mesure.

Dans un mode de réalisation, l'étape de dissipation thermique peut être réalisée par ledit dissipateur thermique.

Dans un mode de réalisation, l'étape de dissipation thermique peut être réalisée en outre par un flux d'air passant dans le dissipateur thermique et généré par au moins une ouverture de passage d'air débouchant au niveau du dissipateur thermique.

### DESCRIPTION DES FIGURES ET MODES DE REALISATION

D'autres avantages et caractéristiques apparaîtront à l'examen de la description détaillée d'exemples de réalisation nullement limitatifs, et des dessins annexés sur lesquels :
- la FIGURE 1 est une représentation schématique d'une coupe de profil d'un premier exemple du dispositif selon l'invention ;
- la FIGURE 2 est une représentation schématique d'une vue éclatée en perspective d'un deuxième exemple du dispositif selon l'invention ; et
- la FIGURE 3 est une représentation schématique d'un exemple du procédé selon l'invention.

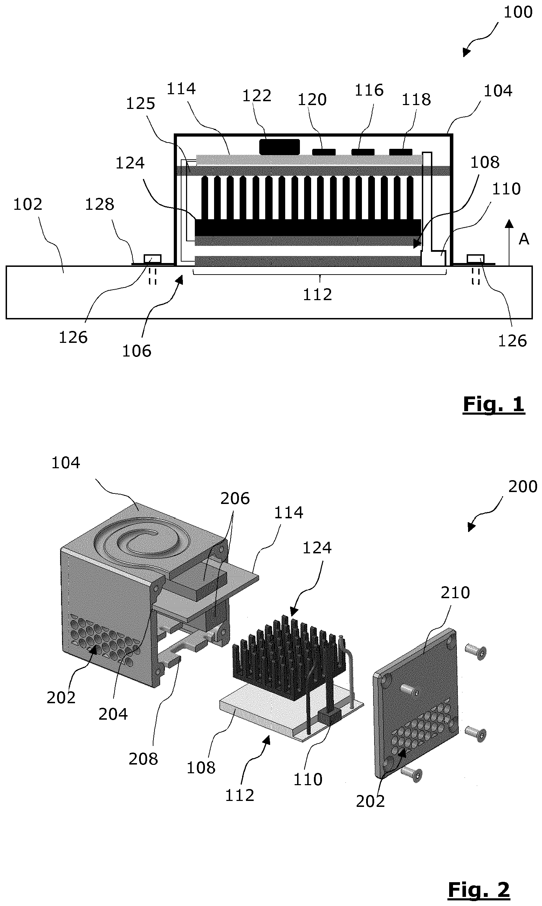

La FIGURE 1 est une représentation schématique d'une coupe de profil d'un premier exemple du dispositif selon l'invention.

Le dispositif 100 est prévu pour mesurer la température d'un échantillon 102 ; ladite température peut être comprise entre -50°C et 250°C. Le dispositif 100 comprend un boitier 104 comprenant au moins une ouverture 106 du côté de l'échantillon 102.

Le boitier 104 est en aluminium. Dans une variante, le boitier 104 est en polyuréthane.

Le dispositif 100 comprend un thermo-générateur 108 et un capteur de température 110 situés du côté de l'ouverture 106. Le thermo-générateur 108 et le capteur de température 110 forment, du côté de l'ouverture 106, une surface 112, dite surface de mesure. Cette surface de mesure 112 est plane.

La surface de mesure 112 est maintenue en contact thermique avec l'échantillon 102.

Le capteur de température 110 est configuré pour mesurer une température de l'échantillon 102 et le thermo-générateur 108 est agencé pour convertir une énergie thermique de la surface de mesure 112 en une énergie électrique pour alimenter le capteur de température 110. En particulier, le thermo-générateur 108 est de préférence un module Peltier.

Le dispositif 100 comprend aussi une carte électronique 114 configurée pour, d'une part, recevoir une énergie électrique convertie par le thermo-générateur 108 et, d'autre part, alimenter le capteur de température 110 avec cette énergie électrique. Le thermo-générateur 108 et le capteur de température 110 sont disposés entre la surface de mesure 112 et la carte électronique 114.

La carte électronique 114 comprend un convertisseur de tension 116, en particulier du type élévateur de tension, relié au thermo-générateur 108. Le convertisseur de tension 116 est agencé pour élever une tension convertie par le thermo-générateur 108 comprise entre 30 et 500 mV à une tension comprise entre 2 et 5 V.

La carte électronique 114 comprend aussi une capacité 118, du type supercapacité, configurée pour stocker l'énergie électrique produite par le thermo-générateur 108. La capacité 118 est relié au convertisseur de tension 116 et stocke l'énergie électrique à la tension fournie par le convertisseur de tension 116. La capacité 118 est reliée au capteur de température 110 et est configurée pour l'alimenter.

Le dispositif 100 comprend en outre un moyen de communication 120, vers un serveur distant, de données relatives à une température mesurée par le capteur de température 110. Le moyen de communication 120 est intégré à la carte électronique 114 et peut être tout moyen de communication sans fil, tel que par Bluetooth^{®}, wifi^{™}, LoRa, SigFox, etc. Le moyen de communication 120 est aussi agencé pour recevoir des données de commande depuis le serveur distant.

Le dispositif 100 comprend un microcontrôleur 122 prévu pour contrôler les composants électroniques de la carte électronique 114. Par exemple, le microcontrôleur 122 commande le stockage par la capacité 118 de l'énergie électrique convertie. Le microcontrôleur 122 contrôle aussi l'alimentation du capteur de température 110 et la transmission par le moyen de communication 120 d'une mesure de température du capteur de température 110.

La carte électronique 114 est disposée à une distance non nulle de la surface de mesure 112, cette distance de mesure étant mesurée dans une direction A perpendiculaire à la surface de mesure 112. Cet agencement permet de limiter les températures auxquelles sont soumis les composants de la carte électronique 114. La distance entre la surface de mesure 112 et la carte électronique 114 est supérieure à 1 cm, de préférence supérieure à 1,5 cm, par exemple égale à 2,5 cm. Contrairement à l'état de la technique, les composants électroniques du dispositif 100 ne sont pas exposés à des températures élevées, ce qui améliore la robustesse du dispositif 100.

Le dispositif 100 comprend un dissipateur thermique 124 disposé entre le thermo-générateur 108 et la carte électronique 114. Le dissipateur 124 est agencé en contact thermique avec une surface, dite de dissipation, du thermo-générateur 108, opposée à la surface de mesure 112. Le dissipateur 124 maintient la surface de dissipation à une température différente de la température de la surface de mesure 112. Le thermo-générateur 108 produit de l'énergie électrique en fonction de la différence de température entre la surface de mesure 112 et la surface de dissipation. Le dissipateur thermique 124 est en métal et/ou en plastique. Le dissipateur 124 est collé à la surface de dissipation, par une colle thermique et/ou une pâte adhésive, pour assurer un contact thermique avec ladite surface. Cet agencement permet une meilleure dispersion de l'énergie thermique de la surface de dissipation et donc une différence de température plus importante entre la surface de mesure 112 et la surface de dissipation. L'énergie électrique produite par le thermo-générateur 108 est ainsi augmentée.

Un des avantages de ce mode de réalisation empilant le thermo-générateur 108 et la carte électronique 114 est de permettre de limiter l'aire de contact du dispositif 100 avec l'échantillon 102 quasiment uniquement au thermo-générateur 108 et donc d'optimiser la puissance récupérée par le dispositif 100 car quasiment toute cette aire de contact est occupée par le thermo-générateur 108 et donc travaille de manière utile.

Le dispositif 100 comprend une paroi 125 divisant le boitier 104 en compartiments formants au moins un logement comprenant la carte électronique 114. Le logement est agencé pour isoler thermiquement la carte électronique 114 de la surface de mesure 112. Par exemple, le logement comprend de la mousse polyuréthane pour isoler la carte électronique 114. De plus, la paroi 125 est en contact thermique avec le dissipateur 124 de sorte à maintenir la carte électronique 114 à une température de fonctionnement des composants électronique.

Le dispositif 100 comprend des vis de fixation 126 du boitier 104 à l'échantillon 102, à travers des languettes de fixation 128 prévues dans le boitier 104. Les vis de fixation 126 et les languettes de fixation 128 sont agencées pour maintenir la surface de mesure 112 en contact avec l'échantillon 102.

De préférence, l'échantillon 102 est une boite d'essieu d'un véhicule ferroviaire et le dispositif 100 est configuré pour mesurer une température de ladite boite d'essieu, en ayant la surface de mesure 112 en contact thermique avec la boite d'essieu.

La FIGURE 2 est une représentation schématique d'une vue éclatée en perspective d'un deuxième exemple du dispositif selon l'invention.

Le dispositif 200 comprend les mêmes éléments que le dispositif 100 de la FIGURE 1. De plus, le dispositif 200 comprend des ouvertures 202 prévues pour le passage d'air dans le boitier 104. Les ouvertures 202 sont situées sur des parois latérales du boitier 104 débouchant au niveau du dissipateur thermique 124.

En outre, la carte électronique 114 comprend des composants électroniques 206, tels que le convertisseur de tension 116, la capacité 118, le moyen de communication 120, etc., disposés sur les deux faces de la carte électronique 114. Le boitier 104 comprend deux rainures 204 agencées pour recevoir la carte électronique 114 et la maintenir dans le boitier 104.

Le boitier 104 comprend aussi une séparation 208 sur laquelle est disposé le dissipateur thermique 124 et permet de le maintenir au niveau de la surface de dissipation du thermo-générateur 108.

Par ailleurs, le capteur de température 110 est intégré au thermo-générateur 108. L'ensemble capteur de température 110 et thermo-générateur 108 est fixé à la séparation 208 par exemple par clips ou par emboitement.

Les dimensions du boitier 104 sont 3 cm x 3 cm x 3cm et la carte électronique 114 est disposée à une distance de 2,5 cm de la surface de mesure 112.

Le boitier 104 comprend une paroi 210 amovible permettant l'accès au composants du dispositif 200 pour l'assemblage ou l'entretien du dispositif 200. La mise en œuvre du dispositif 200 est ainsi plus simple.

En particulier, pour un échantillon ayant une température de 100°C, la carte électronique 114 est maintenue à une température de 50°C, respectant la température de fonctionnement des composants 206, par le dispositif 200 selon l'invention.

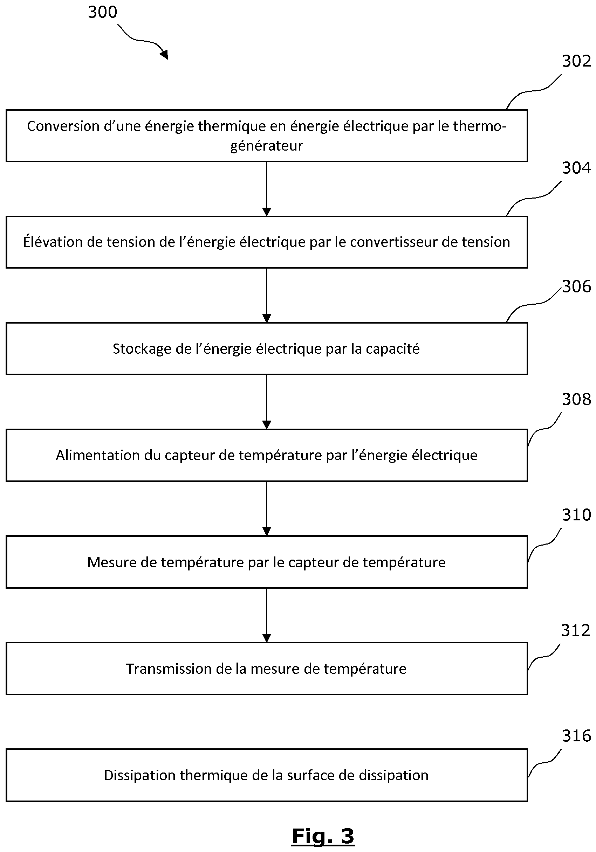

La FIGURE 3 est une représentation schématique d'un exemple du procédé selon l'invention.

Le procédé 300 est un procédé de mesure de température mis en œuvre par le dispositif 100 de la FIGURE 1 et/ou le dispositif 200 de la FIGURE 2.

Le procédé 300 comprend une étape 302 de conversion d'une énergie thermique en énergie électrique par le thermo-générateur 102.

Ensuite, le procédé 300 comprend une étape 304 d'élévation de tension de l'énergie électrique par le convertisseur de tension 116.

Le procédé 300 comprend aussi une étape 306 d'élévation de tension de l'énergie électrique par la capacité 118.

Le procédé 300 comprend aussi une étape 308 d'alimentation du capteur de température 110 par de l'énergie électrique stockée par la capacité 118.

Ensuite, le procédé 300 comprend une étape 310 de mesure de température par le capteur de température 110.

Le procédé 300 comprend en outre une étape 312 de transmission de la mesure de température par le moyen de communication de données 120.

Le procédé 300 comprend aussi une étape 316 de dissipation thermique de la surface de dissipation du thermo-générateur 108. Cette étape 312 est réalisée par le dissipateur thermique 124.

L'étape 316 du procédé 300 mis en œuvre par le dispositif 200 est réalisée, en outre, par un flux d'air passant dans le dissipateur thermique 124 et généré par les ouvertures 202 de passage d'air. Cette étape 316 est mise en œuvre simultanément à chacune des étapes 302, 304, 306, 308, 310, et 312.

## Revendications

1. Dispositif (100; 200) de mesure de température comprenant :
- un capteur de température (110) agencé pour mesurer une température,
- un thermo-générateur (108) formant avec ledit capteur de température, une surface (112) dite de mesure, ledit thermo-générateur (108) étant configuré pour convertir une énergie thermique de ladite surface de mesure (112) en une énergie électrique et ledit capteur (110) étant agencé pour mesurer une température d'un échantillon (102) en contact avec la surface de mesure (112),
- un dissipateur thermique (124) et
- une carte électronique (114) agencée pour recevoir l'énergie électrique convertie par le thermo-générateur (108) et alimenter ledit capteur de température (110) avec au moins une partie de cette énergie électrique, la carte électronique (114) comprenant des composants électroniques (116, 118, 120);
la carte électronique (114) étant agencée à une distance non-nulle de ladite surface de mesure (112) dans une direction (A) perpendiculaire à ladite surface de mesure (112),
**caractérisé en ce que** :
- le dissipateur thermique (124) est disposé entre la carte électronique (114) et le thermo-générateur (108) et est en contact thermique avec une surface de dissipation du thermo-générateur (108) agencée pour être à une température différente de la température de la surface de mesure (112) de manière à produire de l'énergie électrique en fonction de la différence de température entre la surface de mesure (112) et la surface de dissipation,
- le dispositif (100; 200) comprend un boitier (104) contenant le capteur de température (110), le thermo-générateur (108) et la carte électronique (114), la surface de mesure (112) étant formée sur un côté dudit boitier (104).

2. Dispositif (100; 200) selon la revendication précédente, **caractérisé en ce que** le capteur de température (110) et/ou le thermo-générateur (108) sont situés entre la surface de mesure (112) et la carte électronique (114).

3. Dispositif (100; 200) selon l'une quelconque des revendications précédentes, **caractérisé en ce que** la carte électronique (114) comprend au moins un convertisseur de tension (116) reliant le thermo-générateur (108) au capteur de température (110).

4. Dispositif (100; 200) selon l'une quelconque des revendications précédentes, **caractérisé en ce que** la carte électronique (114) comprend un microcontrôleur (122) agencé pour contrôler :
- au moins un moyen de stockage (118) de l'énergie électrique convertie par le thermo-générateur (108) et agencé pour alimenter le capteur de température (110) avec au moins une partie de cette énergie électrique stockée, et/ou
- un moyen de communication (120) d'une mesure de température dudit capteur de température (110) avec un serveur distant.

5. Dispositif (200) selon l'une quelconque des revendications précédentes, **caractérisé en ce que** le boitier (104) comprend au moins une ouverture de passage (202) d'air débouchant au niveau du dissipateur thermique (124).

6. Dispositif (100) selon l'une quelconque des revendications précédentes, **caractérisé en ce que** la carte électronique (114) est disposée dans un logement l'isolant thermiquement de la surface de mesure (112).

7. Dispositif (100; 200) selon l'une quelconque des revendications précédentes, **caractérisé en ce qu'**il comprend au moins un moyen de mesure d'une donnée relative à l'environnement dudit dispositif (100; 200) et **en ce que** la carte électronique (114) est agencée pour alimenter ledit moyen de mesure avec au moins une partie de l'énergie électrique convertie par le thermo-générateur (108).

8. Dispositif (100) selon l'une quelconque des revendications précédentes, **caractérisé en ce qu'**il comprend des moyens de fixation (126, 128) de la surface de mesure (112) sur l'échantillon (102).

9. Système de mesure de température comprenant un dispositif (100; 200) selon l'une quelconque des revendications précédentes assemblé à un échantillon (102) **caractérisé en ce que** la surface de mesure (112) formée par le thermo-générateur (108) et le capteur de température (110) est en contact thermique avec l'échantillon (102) de sorte à en mesurer une température.

10. Véhicule, en particulier ferroviaire, comprenant au moins un dispositif (100; 200) selon l'une quelconque des revendications 1 à 8 dont la surface de mesure (112) est située au niveau d'au moins une boite d'essieu dudit véhicule et prévu pour mesurer une température de ladite au moins une boite d'essieu.

11. Procédé (300) de mesure de température d'un échantillon (102) à l'aide d'un dispositif (100; 200) selon l'une quelconque des revendications 1 à 8, ce procédé comprenant au moins les étapes suivantes :
- conversion (302) par le thermo-générateur (108) dudit dispositif (100; 200) en énergie électrique d'une énergie thermique de ladite surface de mesure (112),
- réception (308) de ladite énergie électrique convertie par la carte électronique (114) dudit dispositif (100; 200) pour alimenter ledit capteur de température avec au moins une partie de cette énergie électrique.

12. Procédé (300) selon la revendication précédente, **caractérisé en ce qu'**il comprend une étape d'élévation (304) d'une tension de l'énergie électrique convertie par au moins un convertisseur de tension (116) reliant le thermo-générateur (108) au capteur de température (110).

13. Procédé (300) selon la revendication 11 ou 12, **caractérisé en ce qu'**il comprend :
- au moins une étape de stockage (306) de l'énergie électrique convertie par le thermo-générateur (108) par au moins un moyen de stockage (118) agencé pour alimenter le capteur de température (110) avec au moins une partie de cette énergie électrique stockée, et/ou
- au moins une étape de communication (312) d'une mesure de température dudit capteur (110) avec un serveur distant.

14. Procédé (300) selon l'une quelconque des revendications 11 à 13, **caractérisé en ce qu'**il comprend une étape de dissipation thermique (316) de ladite surface de dissipation du thermo-générateur (108) opposée à la surface de mesure (112) de sorte que la température de la surface de dissipation est différente de la température de la surface de mesure (112).

15. Procédé (300) selon la revendication précédente, **caractérisé en ce que** l'étape de dissipation thermique (316) est réalisée par ledit dissipateur thermique (124).

16. Procédé selon la revendication précédente, **caractérisé en ce que** l'étape de dissipation thermique (316) est réalisée en outre par un flux d'air passant dans le dissipateur thermique (124) et généré par l'une au moins desdites ouvertures (202) de passage d'air débouchant au niveau du dissipateur thermique (124).

## Patentansprüche

1. Vorrichtung (100; 200) zur Temperaturmessung, umfassend:
- einen Temperatursensor (110), der dazu eingerichtet ist, eine Temperatur zu messen,
- einen Thermogenerator (108), der mit dem Temperatursensor eine als Messfläche bezeichnete Oberfläche (112) bildet, wobei der Thermogenerator (108) dazu konfiguriert ist, thermische Energie der Messfläche (112) in elektrische Energie umzuwandeln, und wobei der Sensor (110) dazu eingerichtet ist, eine Temperatur eines Messobjekts (102) zu messen, das in Kontakt mit der Messfläche (112) steht,
- eine Wärmeableitvorrichtung (124) und
- eine Elektronikplatine (114), die dazu eingerichtet ist, die von dem Thermogenerator (108) umgewandelte elektrische Energie zu empfangen und den Temperatursensor (110) mit zumindest einem Teil dieser elektrischen Energie zu versorgen, wobei die Elektronikplatine (114) elektronische Komponenten (116, 118, 120) aufweist;
wobei die Elektronikplatine (114) in einem Abstand ungleich Null von der Messfläche (112) in einer Richtung (A) orthogonal zu der Messfläche (112) angeordnet ist,
**dadurch gekennzeichnet, dass**:
- die Wärmeableitvorrichtung (124) zwischen der Elektronikplatine (114) und dem Thermogenerator (108) angeordnet ist und in thermischem Kontakt mit einer Ableitungsfläche des Thermogenerators (108) steht, die so eingerichtet ist, dass sie eine von der Temperatur der Messfläche (112) verschiedene Temperatur aufweist, um elektrische Energie in Abhängigkeit von der Temperaturdifferenz zwischen der Messfläche (112) und der Ableitungsfläche zu erzeugen,
- die Vorrichtung (100; 200) ein Gehäuse (104) aufweist, das den Temperatursensor (110), den Thermogenerator (108) und die Elektronikplatine (114) enthält, wobei die Messfläche (112) auf einer Seite des Gehäuses (104) ausgebildet ist.

2. Vorrichtung (100; 200) nach dem vorhergehenden Anspruch, **dadurch gekennzeichnet, dass** der Temperatursensor (110) und/oder der Thermogenerator (108) zwischen der Messfläche (112) und der Elektronikplatine (114) angeordnet sind.

3. Vorrichtung (100; 200) nach einem der vorhergehenden Ansprüche, **dadurch gekennzeichnet, dass** die Elektronikplatine (114) mindestens einen Spannungswandler (116) aufweist, der den Thermogenerator (108) mit dem Temperatursensor (110) verbindet.

4. Vorrichtung (100; 200) nach einem der vorhergehenden Ansprüche, **dadurch gekennzeichnet, dass** die Elektronikplatine (114) einen Mikrocontroller (122) aufweist, der dazu eingerichtet ist, zu steuern:
- mindestens ein Speichermittel (118) für elektrische Energie, die mittels des Thermogenerators (108) umgewandelt wird, das dazu eingerichtet ist, den Temperatursensor (110) mit zumindest einem Teil dieser gespeicherten elektrischen Energie zu versorgen, und/oder
- ein Mittel (120) zur Kommunikation einer Temperaturmessung des Temperatursensors (110) mit einem entfernt befindlichen Server.

5. Vorrichtung (200) nach einem der vorhergehenden Ansprüche, **dadurch gekennzeichnet, dass** das Gehäuse (104) mindestens eine Luftdurchgangsöffnung (202) aufweist, die im Bereich der Wärmeableitvorrichtung (124) mündet.

6. Vorrichtung (100) nach einem der vorhergehenden Ansprüche, **dadurch gekennzeichnet, dass** die Elektronikplatine (114) in einer thermischen Aufnahme der Messfläche (112) angeordnet ist.

7. Vorrichtung (100; 200) nach einem der vorhergehenden Ansprüche, **dadurch gekennzeichnet, dass** diese mindestens ein Mittel zur Messung von Daten betreffend die Umgebung der Vorrichtung (100; 200) umfasst und dass die Elektronikplatine (114) dazu eingerichtet ist, dieses Messmittel mit zumindest einem Teil der durch den Thermogenerator (108) umgewandelten elektrischen Energie zu versorgen.

8. Vorrichtung (100) nach einem der vorhergehenden Ansprüche, **dadurch gekennzeichnet, dass** diese Mittel (126, 128) zur Befestigung der Messfläche (112) an dem Messobjekt (102) umfasst.

9. System zur Temperaturmessung, aufweisend eine an einem Messobjekt (102) montierte Vorrichtung (100; 200) nach einem der vorhergehenden Ansprüche, **dadurch gekennzeichnet, dass** die durch den Thermogenerator (108) und den Temperatursensor (110) gebildete Messfläche (112) derart in thermischem Kontakt mit dem Messobjekt (102) steht, dass eine Temperatur davon gemessen wird.

10. Fahrzeug, insbesondere Schienenfahrzeug, aufweisend mindestens eine Vorrichtung (100; 200) nach einem der Ansprüche 1 bis 8, deren Messfläche (112) sich im Bereich mindestens eines Achslagers des Fahrzeugs befindet und die dazu vorgesehen ist, eine Temperatur des mindestens einen Achslagers zu messen.

11. Verfahren (300) zum Messen der Temperatur eines Messobjekts (102) mit Hilfe einer Vorrichtung (100; 200) nach einem der Ansprüche 1 bis 8, wobei das Verfahren mindestens die folgenden Schritte umfasst:
- Umwandlung (302) einer thermischen Energie der Messfläche (112) in elektrische Energie mittels des Thermogenerators (108) der Vorrichtung (100; 200),
- Empfang (308) der umgewandelten elektrischen Energie durch die Elektronikplatine (114) der Vorrichtung (100; 200), um den Temperatursensor mit zumindest einem Teil dieser elektrischen Energie zu versorgen.

12. Verfahren (300) nach dem vorhergehenden Anspruch, **dadurch gekennzeichnet, dass** dieses einen Schritt der Erhöhung (304) einer Spannung der elektrischen Energie umfasst, die mittels mindestens eines Spannungswandlers (116), der den Thermogenerator (108) mit dem Temperatursensor (110) verbindet, gewandelt wird.

13. Verfahren (300) nach Anspruch 11 oder 12, **dadurch gekennzeichnet, dass** dieses umfasst:
- mindestens einen Schritt der Speicherung (306) der durch den Thermogenerator (108) umgewandelten elektrischen Energie mittels mindestens eines Speichermittels (118), das dazu eingerichtet ist, den Temperatursensor (110) mit zumindest einem Teil dieser gespeicherten elektrischen Energie zu versorgen, und/oder
- mindestens einen Schritt der Kommunikation (312) einer Temperaturmessung des Sensors (110) mit einem entfernt befindlichen Server.

14. Verfahren (300) nach einem der Ansprüche 11 bis 13, **dadurch gekennzeichnet, dass** dieses einen Schritt der Wärmeableitung (316) von der der Messfläche (112) gegenüberliegenden Wärmeableitungsfläche des Thermogenerators (108) umfasst, so dass die Temperatur der Wärmeableitungsfläche von der Temperatur der Messfläche (112) verschieden ist.

15. Verfahren (300) nach dem vorhergehenden Anspruch, **dadurch gekennzeichnet, dass** der Schritt der Wärmeableitung (316) mittels der Wärmeableitvorrichtung (124) realisiert wird.

16. Verfahren nach dem vorhergehenden Anspruch, **dadurch gekennzeichnet, dass** der Wärmeableitungsschritt (316) zusätzlich durch einen Luftstrom realisiert wird, der in der Wärmeableitvorrichtung (124) strömt und durch mindestens eine der Luftdurchgangsöffnungen (202) erzeugt wird, die im Bereich der Wärmeableitvorrichtung (124) münden.

## Claims

1. Temperature measurement device (100; 200) comprising:
- a temperature sensor (110) arranged to measure a temperature,
- a thermo-generator (108) forming, with said temperature sensor, a surface (112) so-called measurement surface (112), said thermo-generator (108) being configured to convert thermal energy of said measurement surface (112) into electrical energy and said sensor (110) being arranged to measure a temperature of a sample (102) in contact with the measurement surface (112),
- a heat sink (124), and
- an electronic board (114) arranged to receive the electrical energy converted by the thermo-generator (108) and power said temperature sensor (110) with at least some of this electrical energy, the electronic board (114) comprising electronic components (116, 118, 120), the electronic board (114) being arranged at a non-zero distance from said measurement surface (112) in a direction (A) perpendicular to said measurement surface (112),
**characterized in that**:
- the heat sink (124) is arranged between the electronic board (114) and the thermo-generator (108) and is in thermal contact with a dissipation surface of the thermo-generator (108) arranged to be at a temperature differing from the temperature of the measurement surface (112) so as to generate electrical energy as a function of the temperature difference between the measurement surface (112) and the dissipation surface,
- the device (100; 200) comprising a box (104) containing the temperature sensor (110), the thermo-generator (108) and the electronic board (114), the measurement surface (112) being formed on one side of said box (104).

2. Device (100; 200) according to the preceding claim, **characterized in that** the temperature sensor (110) and/or the thermo-generator (108) are located between the measurement surface (112) and the electronic board (114).

3. Device (100; 200) according to any one of the preceding claims, **characterized in that** the electronic board (114) comprises at least one voltage converter (116) connecting the thermo-generator (108) to the temperature sensor (110).

4. Device (100; 200) according to any one of the preceding claims, **characterized in that** the electronic board (114) comprises a microcontroller (122) arranged to control:
- at least one means (118) for storing the electrical energy converted by the thermo-generator (108) and arranged to power the temperature sensor (110) with at least some of this stored electrical energy, and/or
- a means (120) for communicating a temperature measurement of said temperature sensor (110) with a remote server.

5. Device (200) according to any one of the preceding claims, **characterized in that** the box (104) comprises at least one air passage opening (202) that leads to the heat sink (124).

6. Device (100) according to any one of the preceding claims, **characterized in that** the electronic board (114) is positioned in a housing thermally insulating it from the measurement surface (112).

7. Device (100; 200) according to any one of the preceding claims, **characterized in that** it comprises at least one means for measuring an item of data relating to the environment of said device (100; 200) and **in that** the electronic board (114) is arranged to power said measurement means with at least some of the electrical energy converted by the thermo-generator (108).

8. Device (100) according to any one of the preceding claims, **characterized in that** it comprises means (126, 128) for fixing the measurement surface (112) to the sample (102).

9. Temperature measurement system comprising a device (100; 200) according to any one of the preceding claims assembled with a sample (102), **characterized in that** the measurement surface (112) formed by the thermo-generator (108) and the temperature sensor (110) is in thermal contact with the sample (102) so as to measure a temperature thereof.

10. Vehicle, in particular rail vehicle, comprising at least one device (100; 200) according to any one of claims 1 to 8, the measurement surface (112) of which is located at the level of at least one axle box of said vehicle and provided to measure a temperature of said at least one axle box.

11. Method (300) for measuring the temperature of a sample (102) using a device (100; 200) according to any one of claims 1 to 8, this method comprising at least the following steps:
- conversion (302) by the thermo-generator (108) of said device (100; 200) into electrical energy of a thermal energy of said measurement surface (112),
- receipt (308) of said converted electrical energy by the electronic board (114) of said device (100; 200) in order to power said temperature sensor with at least some of this electrical energy.

12. Method (300) according to the preceding claim, **characterized in that** it comprises a step (304) of increasing a voltage of the converted electrical energy by at least one voltage converter (116) connecting the thermo-generator (108) to the temperature sensor (110).

13. Method (300) according to claim 11 or 12, **characterized in that** it comprises:
- at least one step (306) of storage of the electrical energy converted by the thermo-generator (108) by at least one storage means (118) arranged to power the temperature sensor (110) with at least some of this stored electrical energy, and/or
- at least one step (312) of communication of a temperature measurement of said sensor (110) with a remote server.

14. Method (300) according to any one of claims 11 to 13, **characterized in that** it comprises a step of thermal dissipation (316) of said dissipation surface of the thermo-generator (108) opposite the measurement surface (112) so that the temperature of the dissipation surface differs from the temperature of the measurement surface (112).

15. Method (300) according to the preceding claim, **characterized in that** the thermal dissipation step (316) is carried out by a heat sink (124).

16. Method according to the preceding claim, **characterized in that** the thermal dissipation step (316) is moreover carried out by an air flow passing into the heat sink (124) and generated by at least one of said air passage openings (202) that lead to the heat sink (124).
